# EUROPEAN PATENT APPLICATION

(11) **EP 1 270 632 A1**
(43) Date of publication of application: **02.01.2003**
(21) Application number: 01963442.7
(22) Date of filing: 05.09.2001
(51) Int. Cl.: C08G 59/14, C08J 5/24, B32B 27/38

(54) **PHOSPHORUS-CONTAINING EPOXY RESIN, FLAME-RETARDANT HIGHLY HEAT-RESISTANT EPOXY RESIN COMPOSITION CONTAINING THE RESIN, AND LAMINATE**

(30) Priority: 12.09.2000 JP 2000276031; 07.11.2000 JP 2000338606
(71) Applicant: Mitsui Chemicals, Inc., Tokyo 100-6070 (JP)
(72) Inventor: YASUDA, Kiyomi, c/o MITSUI CHEMICALS, INC, Chiba 299-0265 (JP); SUZUKI, Terufumi, c/o MITSUI CHEMICALS, INC, Chiba 299-0265 (JP); TAHARA, Shuji, c/o MITSUI CHEMICALS, INC, Chiba 299-0265 (JP)
(74) Representative: Cresswell, Thomas Anthony
(86) International application number: JP0107701
(87) International publication number: WO02022704

(57) **Abstract**

A phosphorous epoxy resin of the invention being obtainable by reacting an organophosphorus compound, a trifunctional epoxy resin and a bifunctional epoxy resin optionally together with a bifunctional phenol compound. A flame-resistant highly thermally stable epoxy resin composition is also provided, which contains the above phosphorous epoxy resin. A cured product with excellent flame resistance and thermal stability can be obtained from the phosphorous epoxy resin, which cured product is useful as a prepreg or a laminate.

## Description

### TECHNICAL FIELD

The present invention relates to a phosphorous epoxy resin which can realize excellent flame resistance and high thermal stability without the need to use any halide flame retardant agent, to a flame-resistant highly thermally stable epoxy resin composition which contains the phosphorous epoxy resin, and to a prepreg and laminate obtained with the use of the flame-resistant highly thermally stable epoxy resin composition.

### BACKGROUND OF THE INVENTION

Epoxy resin compositions, although widely used in, for example, electrical and electronic equipment components by virtue of their excellent properties, are often furnished with a flame resistance in order to ensure safety against fire. For furnishing such resins with the flame resistance, it is common to use halide compounds such as an epoxy bromide. Although halide compounds have excellent flame resistance, such an environmental problem that a thermal decomposition thereof would cause formation of hazardous halides, such as hydrogen halides, and polybrominated dibenzodioxine and furan has become pointed out. In these circumstances, phosphorus compounds as a flame retardant agent for replacing the bromide flame retardant agent are now being studied.

With respect to the mechanism of flame resistance realization with the use of phosphorus compounds, an outline is described on, for example, page 113 of "Latest Flame Retardant Agent and Technology for Flame Resistance" published by Technical Information Institute Co., Ltd., Japan, in 1999. As phosphorus compounds for imparting a flame resistance, various compounds are being investigated. In particular, methods of incorporating a phosphorus compound in the skeleton of epoxy resin through some chemical reaction with the epoxy resin are being investigated in order not to deteriorate the excellent properties, for example, thermal stability of epoxy resin cured product.

For example, a method of using a phosphorus compound having an active hydrogen capable of reacting with an epoxy group for attaining the incorporation of phosphorus compound in the epoxy resin has been disclosed. As such a phosphorus compound, use is made of, for example, a phosphorus compound having one active hydrogen such as 9,10-dihydro-9-oxa-10-phosphaphenanthrene-10-oxide described in Japanese Patent Application No. 43(1968)-34168, or a phosphorus compound having two active hydrogens such as 10-(2,5-dihydroxyphenyl)-10H-9-oxa-10-phosphaphenanthre ne-10-oxide described in Japanese Patent Application No. 58(1983)-231508.

However, when use is made of a phosphorus compound having one active hydrogen capable of reacting with an epoxy group, it acts as an end-terminating agent in the reaction with the epoxy resin, so that the obtained cured product has an incomplete network structure. Thus, the thermal stability thereof would be poor. From this viewpoint, the method of using a phosphorus compound having two active hydrogens capable of reacting with an epoxy group is being investigated. However, even when use is made of a phosphorus compound having two active hydrogens capable of reacting with an epoxy group, a cured product having excellent thermal stability as required for, for example, semiconductor substrates cannot be obtained by the hitherto proposed methods (for example, Japanese Patent Application No. 11(1999)-16485).

Accordingly, it is an object of the present invention to provide a phosphorous epoxy resin from which a cured product with excellent flame resistance and high thermal stability can be obtained without the need to use any halide flame retardant agent, a flame-resistant highly thermally stable epoxy resin composition which contains the phosphorous epoxy resin, and a prepreg, insulating layer and laminate obtained with the use of the flame-resistant highly thermally stable epoxy resin composition.

### DISCLOSURE OF THE INVENTION

The inventors have made extensive and intensive studies with a view toward solving the above problems. As a result, the use of specified components such as a trifunctional epoxy resin in specified amounts has enabled accomplishing a phosphorous epoxy resin which can realize an excellent flame resistance and a high thermal stability without the need to use any halide flame retardant agent, a flame-resistant highly thermally stable epoxy resin composition which contains the phosphorous epoxy resin, and a prepreg or laminate obtained with the use of the flame-resistant highly thermally stable epoxy resin composition. In this connection, it has been found that, as the phosphorous epoxy resin, one obtained by reacting an organophosphorus compound having two or more active hydrogens capable of reacting with an epoxy group with a trifunctional epoxy resin having an aromatic ring is especially preferred. These have enabled completing the present invention.

Therefore, the gist of the present invention is as follows.

The phosphorous epoxy resin of the present invention is obtainable by reacting 5 to 50 parts by weight of an organophosphorus compound, 30 to 70 parts by weight of a trifunctional epoxy resin, 5 to 50 parts by weight of a bifunctional epoxy resin and 0 to 20 parts by weight of a bifunctional phenol compound. Provided, however, that the amount in terms of parts by weight of each of the above components is per 100 parts by weight of the phosphorous epoxy resin.

It is preferred that the organophosphorus compound be an organophosphorus compound capable of reacting with an epoxy group.

It is further preferred that the organophosphorus compound have two or more active hydrogens, and that the trifunctional epoxy resin have an aromatic ring.

The organophosphorus compound is preferably an organophosphorus compound obtained by reacting a compound having one active hydrogen bonded with a phosphorus atom with a quinone compound.

The phosphorous epoxy resin of the present invention preferably has an epoxy equivalent of 250 to 1000 g/eq.

The flame-resistant highly thermally stable epoxy resin composition of the present invention comprises the above phosphorous epoxy resin and a curing agent.

The prepreg of the present invention is obtainable with the use of the above flame-resistant highly thermally stable epoxy resin composition.

The laminate of the present invention is obtainable with the use of the above flame-resistant highly thermally stable epoxy resin composition.

### PREFERRED EMBODIMENTS OF THE INVENTION

### <Phosphorous epoxy resin>

The phosphorous epoxy resin of the present invention is obtained by reacting a specified amount of organophosphorus compound, a specified amount of trifunctional epoxy resin and a specified amount of bifunctional epoxy resin optionally together with a bifunctional phenol compound. In this connection, detailed description will be made below.

### [Trifunctional epoxy resin]

It is requisite that components derived from the trifunctional epoxy resin for use in the present invention be contained in the phosphorous epoxy resin in an amount of 30 to 70% by weight, especially 35 to 65% by weight, based on the weight of phosphorous epoxy resin.

The amount of trifunctional epoxy resin for use in the production of the phosphorous epoxy resin is preferably in the range of 30 to 70 parts by weight, still preferably 35 to 65 parts by weight, per 100 parts by weight of the sum of organophosphorus compound, trifunctional epoxy resin, bifunctional epoxy resin and bifunctional phenol compound.

When the amount of trifunctional epoxy resin used or the content of components derived from the trifunctional epoxy resin is less than 30% (parts) by weight, not only is it difficult to impart a flame resistance to the cured product but also the glass transition temperature (hereinafter referred to as "Tg") thereof may be unfavorably lowered. On the other hand, when the amount or the content is in excess, the molecular weight thereof may increase to such an extent that the solubility and impregnation capability thereof may be poor.

The trifunctional epoxy resin for use in the present invention is preferably a compound having an aromatic ring. It is obtained by, for example, a condensation of trisphenol compound and epichlorohydrin according to known procedure. The trisphenol compound, although not particularly limited, is preferably selected from among trisphenol compounds of high aromatic ring content, such as
1-[α-methyl-α-(4-hydroxyphenyl)ethyl]-4-[α,α-bis(4-hydroxyphenyl)ethyl]benzene,
1,3,5-tris[α-methyl-α-(4-hydroxyphenyl)ethyl]benzene, 1,1,1-tris(hydroxyphenyl)methane,
1-[α-methyl-α-(4-hydroxyphenyl)ethyl]-3-[α,α-bis(4-hydroxyphenyl)ethyl]benzene and
1,1,1-tris(4-hydroxyphenyl)ethane, from the viewpoint of flame resistance exhibition.

In the trifunctional epoxy resin for use in the present invention, it is desirable that the content of trifunctional glycidylated components is preferably 60% or more, still preferably 80% or more.

When the proportion of glycidylated components of 5 or greater functionality is increased, the molecular weight increase may unfavorably be promoted at the reaction with the organophosphorus compound to such an extent that a decrease of solubility in solvents, a poor impregnation capability to substrates and a lowering of Tg occur. Also, from the same viewpoint, it is preferred to minimize the use of an epoxy resin, especially a novolak epoxy resin, of 4 or greater functionality, rather not to use the same.

### [Organophosphorus compound]

The organophosphorus compound for use in this reaction is preferably a compound capable of reacting with an epoxy group. The organophosphorus compound preferably has two or more active hydrogens. These active hydrogens are preferably capable of reacting with an epoxy group.

The above organophosphorus compound is preferably a compound obtained by reacting a compound having at least one active hydrogen bonded with a phosphorus atom with a quinone compound.

For example, preferably, there can be mentioned organophosphorus compounds obtained by reacting a compound having at least one active hydrogen, such as 9,10-dihydro-9-oxa-10-phosphaphenanthrene-10-oxide or diphenylphosphine oxide, with a quinone compound, such as 1,4-benzoquinone, 1,4-naphthoquinone or toluquinone.

In the present invention, the content of components derived from the organophosphorus compound in the phosphorous epoxy resin is preferably in the range of 5 to 50% by weight, still preferably 10 to 35% by weight.

The amount of organophosphorus compound for use in the production of the phosphorous epoxy resin is preferably in the range of 5 to 50 parts by weight, still preferably 10 to 35 parts by weight, per 100 parts by weight of the sum of organophosphorus compound, trifunctional epoxy resin, bifunctional epoxy resin and bifunctional phenol compound.

When the content or use amount of organophosphorus compound is low, the exhibition of a flame resistance may be unsatisfactory. On the other hand, when it is in excess, the molecular weight of phosphorous epoxy resin may increase to such an extent that the solubility and impregnation capability thereof may be poor.

### [Bifunctional epoxy resin and bifunctional phenol compound]

In the present invention, in order to control the epoxy equivalent so as to fall within the intended range and to attain a cured product performance over a target level, a specified amount of bifunctional epoxy resin is used in combination with the organophosphorus compound and trifunctional epoxy resin.

Furthermore, a bifunctional phenol compound can be used in combination with the organophosphorus compound, trifunctional epoxy resin and bifunctional epoxy resin. The joint use of bifunctional phenol compound facilitates controlling the epoxy equivalent of phosphorous epoxy resin so as to be 350 g/eq or more.

Although the contents of components derived from the bifunctional epoxy resin and the bifunctional phenol compound are varied depending on the type and amount of employed organophosphorus compound and trifunctional epoxy resin, it is preferred that the amount of components derived from the bifunctional epoxy resin be in the range of 5 to 50 parts by weight while the amount of components derived from the bifunctional phenol compound be in the range of 0 to 20 parts by weight, per 100 parts by weight of phosphorous epoxy resin.

Still preferably, the amount of components derived from the bifunctional epoxy resin is in the range of 10 to 40 parts by weight while the amount of components derived from the bifunctional phenol compound is in the range of 0 to 10 parts by weight. It is especially preferred that the content of components derived from the bifunctional phenol compound be in the range of 0 to 7 parts by weight.

The amount of bifunctional epoxy resin for use in the production of the phosphorous epoxy resin is preferably in the range of 5 to 50 parts by weight, still preferably 10 to 40 parts by weight, per 100 parts by weight of the sum of organophosphorus compound, trifunctional epoxy resin, bifunctional epoxy resin and bifunctional phenol compound.

The amount of bifunctional phenol compound for use in the production of the phosphorous epoxy resin is preferably in the range of 0 to 20 parts by weight, still preferably 0 to 10 parts by weight, and optimally 0 to 7 parts by weight, per 100 parts by weight of the sum of organophosphorus compound, trifunctional epoxy resin, bifunctional epoxy resin and bifunctional phenol compound.

When the amount of bifunctional epoxy resin used is too small, the molecular weight of phosphorous epoxy resin may increase to such an extent that the solubility and impregnation capability thereof may be poor. On the other hand, when the amount of bifunctional epoxy resin is in excess, the Tg of cured product may be unfavorably low.

Further, when the amount of bifunctional phenol compound is in excess, the molecular weight of phosphorous epoxy resin may increase to an unfavorable degree.

The bifunctional epoxy resin and bifunctional phenol compound for use can be those commercially available. In particular, bisphenol A, bisphenol E and biphenol compounds and glycidyl derivatives thereof are preferred from the viewpoint of flame resistance and Tg.

### [Other component]

In the present invention, other epoxy resins can be added to the phosphorous epoxy resin. Although there is no particular limitation with respect to the type and amount of added epoxy resins, it is preferred that the use thereof be effected within such a scope that the performance of phosphorous epoxy resin of the present invention is not deteriorated. Polyfunctional epoxyresins of high aromatic ring content, such as an epoxide of aralkyl phenolic resin and an epoxide of o-phenylphenolic novolak resin, are preferred.

### [Phosphorous epoxy resin]

The process for producing the phosphorous epoxy resin of the present invention is not particularly limited. The phosphorous epoxy resin can nearly quantitatively be obtained by mixing together the above specified amount of organophosphorus compound, specified amount of trifunctional epoxy resin and specified amount of bifunctional epoxy resin optionally together with the specified amount of bifunctional phenol compound and other components and by heating the mixture at preferably 100 to 200°C for preferably about 3 to 10 hr to thereby effect a reaction thereof.

The epoxy equivalent of the thus obtained phosphorous epoxy resin is preferably in the range of 250 to 1000 g/eq. Generally, it is still preferably in the range of 350 to 600 g/eq. When the epoxy equivalent falls within the above range, the deterioration of thermal stability after moisture absorption and increase of water absorption with respect to the cured product of phosphorous epoxy resin according to the present invention can be suppressed. Especially when the epoxy equivalent is 350 g/eq or higher, these effects can be exerted satisfactorily.

When the epoxy equivalent is lower, deterioration of the flame resistance and thermal stability may be caused by an increase of the amount of curing agent used. On the other hand, when the epoxy equivalent is greater, the impregnation capability and solubility may be deteriorated, or the Tg of cured product may be unfavorably low.

When it is desired to reduce the amount of curing agent contained in the following flame-resistant highly thermally stable epoxy resin composition, it is preferred that the epoxy equivalent of phosphorous epoxy resin be less than 300 g/eq, especially in the range of 250 to less than 300 g/eq.

### <Flame-resistant highly thermally stable epoxy resin composition and prepreg or laminate thereof>

The flame-resistant highly thermally stable epoxy resin composition of the present invention comprises the above phosphorous epoxy resin and a curing agent. Although curing agents commonly used for the curing agents for epoxy resins can be employed, dicyandiamide, aralkyl phenolic resins, o-phenolicnovolak, p-phenolicnovolak, resorcinol novolak, hydroquinone novolak and the like are preferred in the present invention. Dicyandiamide is especially preferred.

The curing agent is preferably used in an amount of 0.30 to 1.2 eq., still preferably 0.35 to 0.6 eq., per epoxy equivalent of phosphorous epoxy resin.

When dicyandiamide is used, it is preferably used in an amount of 0.35 to 0.7 eq., still preferably 0.35 to 0.6 eq., per epoxy equivalent of phosphorous epoxy resin.

In particular, a specified amount of trifunctional epoxy resin is used in the present invention, so that, even if the amount of used curing agent, such as dicyandiamide, is in the range of 0.35 to 0.45 eq., an epoxy resin capable of realizing excellent flame resistance and thermal stability can be obtained.

Further, the organophosphorus compound having two active hydrogens for use in the present invention can be used as a curing agent in combination therewith.

Acuring accelerator can be added to the flame-resistant highly thermally stable epoxy resin composition of the present invention. As the curing accelerator, imidazoles such as 2-ethyl-4-methylimidazole, 2-phenylimidazole and 1-butyl-2-methylimidazole are suitable. Further, phosphine can be used.

When a solvent is added to the flame-resistant highly thermally stable epoxy resin composition, the type of solvent is not particularly limited as long as it does not react with the flame-resistant highly thermally stable epoxy resin composition. For example, use can be made of ethylene glycol monoethyl ether, ethylene glycol monoethyl ether, propylene glycol monomethyl ether, dimethylformamide, N-methylpyrrolidone, methyl ethyl ketone, cyclohexanone, toluene and xylene. These may be used in combination.

This flame-resistant highly thermally stable epoxy resin composition is reinforced with a glass cloth or glass fibers prior to practical use. This flame-resistant highly thermally stable epoxy resin composition can be loaded with a flame retardant agent of melamine or phosphorus component and a filler such as silica, talc, aluminum oxide hydrate or aluminum hydroxide. When this filler is used, the amount of organophosphorus compound can be reduced. This flame-resistant highly thermally stable epoxy resin composition can be used in not only a prepreg and a laminate but also a surface coating, a copper foil with resin, an adhesive and the like.

When this flame-resistant highly thermally stable epoxy resin composition is used in a laminate, first, it is dissolved in a solvent to thereby obtain a varnish. Subsequently, a glass woven fabric or nonwoven fabric, or a nonglass woven fabric or nonwoven fabric is impregnated with the varnish, and dried at 80 to 170°C, thereby obtaining prepregs. As many prepregs as needed are piled one upon another and coupled with a copper foil. Heating under compression is effected to thereby obtain a laminate. Moreover, the flame-resistant highly thermally stable epoxy resin composition can be used in a coating applied onto a metal foil such as copper foil, or can be compounded with a filler so as to obtain a paste and formed into a sheet, a film or the like before use.

The thus obtained prepregs and laminate can be used in electronic circuits, electronic components, etc.

### INDUSTRIAL APPLICABILITY

The present invention provides the phosphorous epoxy resin from which a cured product of excellent flame resistance and high thermal stability can be produced without the need to use any halide flame retardant agent. Further, the present invention provides the flame-resistant highly thermally stable epoxy resin composition comprising a combination of the phosphorous epoxy resin with the curing agent. Still further, the present invention provides the prepreg or laminate which will be increasingly demanded as a nonhalo material.

### EXAMPLE

The present invention will be further illustrated below with reference to the following Examples, which, however, in no way limit the scope of the invention. Evaluation and measuring were performed in the following manner.

The content of trifunctional epoxide was expressed in terms of histogram area ratio obtained by GPC measurement. As the columns, two Shodex KF801 columns were used in combination with two Shodex KF802 columns. A UV detector was used as the detector, and THF as an eluent was passed through the columns at a flow rate of 1 ml/min.

The epoxy equivalent was measured by the hydrochloric acid/dioxanemethod. Tg was measured by the use of TMA/SS100 manufactured by Seiko Instruments Inc. Measuring was performed in a compression mode under a load of 5 g at a rate of temperature rise of 10°C/min.

With respect to the combustion test, an evaluation was made by a vertical combustion test according to the standard UL-94. Copper foil peel strength and solder heat resistance were measured in accordance with Japanese Industrial Standard (JIS) C6481. In the testing of solder heat resistance, each sample was subjected to a water absorption in a 121°C steam phase of 100% humidity for 5 hr, and immersed in a 260°C solder bath for 20 sec. The occurrence of appearance abnormality, such as blister or peel, was inspected. The solder heat resistance was evaluated as A when there was no appearance abnormality and evaluated as C when there was an appearance abnormality.

In the following Examples and Comparative Examples, 10-(2,5-dihydroxyphenyl)-10H-9-oxa-10-phosphaphenanthre ne-10-oxide (HCA-HQ produced by Sanko Chemical Industry Co., Ltd.), diphenylphosphinylhydroquinone (PPQ produced by Hokko Chemical Industry Co., Ltd.) and 9,10-dihydro-9-oxa-10-phosphaphenanthrene-10-oxide (HCA produced by Sanko Chemical Industry Co., Ltd.) were used as the organophosphorus compound.

### (Synthetic Example 1)

A 5 L separable flask was charged with 70.5 g of organophosphorus compound (10-(2,5-dihydroxyphenyl)-10H-9-oxa-10-phosphaphenanthr ene-10-oxide (HCA-HQ produced by Sanko Chemical Industry Co., Ltd.)), 165 g of epoxy resin of 1-[α-methyl-α-(4-hydroxyphenyl)ethyl]-4-[α,α-bis(4-hydroxyphenyl)ethyl]benzene (TECHMORE VG3101 produced by Mitsui Chemicals, Inc., epoxy equivalent: 210 g/eq, trifunctional glycidylated components: 87%), 64.5 g of bisphenol A epoxy resin (EPOMIK R139S produced by Mitsui Chemicals, Inc.) and 0.1 g of triphenylphosphine, and heated at 150°C for 5 hr. Thus, there was obtained a phosphorous epoxy resin of 472 g/eq. of epoxy equivalent, and 2.25% by weight of phosphorus content.

### (Synthetic Examples 2 to 7)

Phosphorous epoxy resins were produced from the charge materials specified in Table 1 in the same manner as in Synthetic Example 1. The results of Synthetic Examples 2 to 7 are listed in Table 1.

### (Synthetic Example 8)

62.7 g of organophosphorus compound (10-(2,5-dihydroxyphenyl)-10H-9-oxa-10-phosphaphenanthr ene-10-oxide (HCA-HQ produced by Sanko Chemical Industry Co., Ltd.)), 237.3 g of epoxy resin of phenolic novolak (epoxy equivalent: 190 g/eq) and 0.1 g of triphenylphosphine were charged into a 5 L separable flask, heated at 150°C and agitated. In the course of reaction, the reaction product was gelled. Thus, the reaction was discontinued.

### (Synthetic Examples 9 to 11)

Phosphorous epoxy resins were produced from the charge materials specified in Table 1 in the same manner as in Synthetic Example 1. The results of Synthetic Examples 9 to 11 are listed in Table 1.

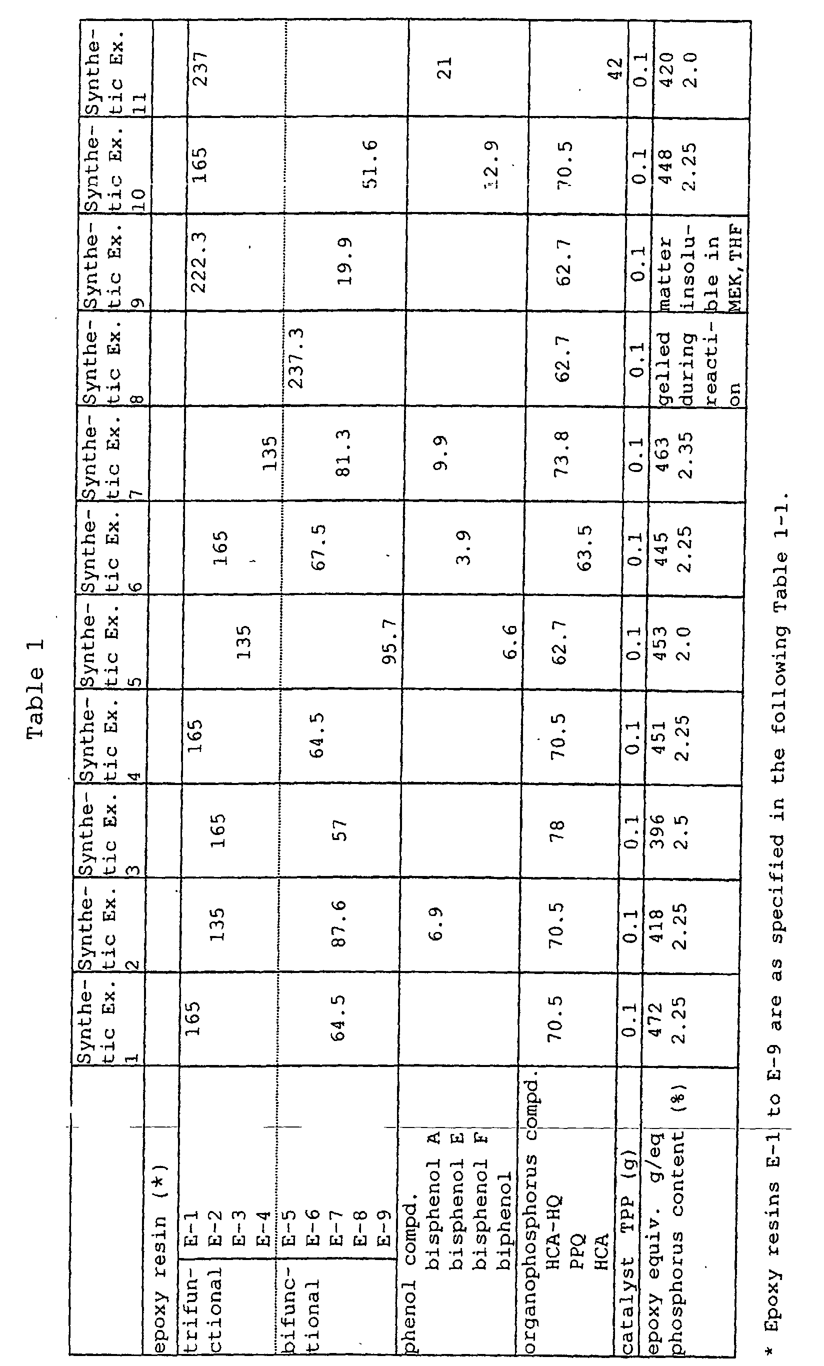

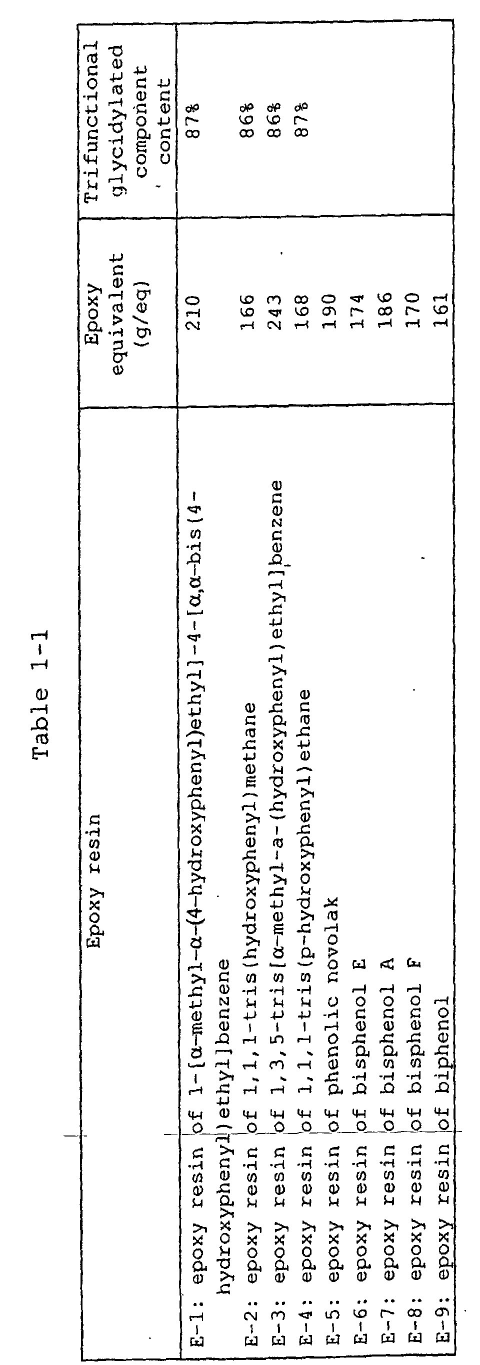

### (Example 1)

100 g of phosphorous epoxy resin obtained in Synthetic Example 1 was dissolved in 50 g of methyl ethyl ketone. 22 g of a solution of 10% by weight dicyandiamide dissolved in a solution consisting of a 3:2 mixture of methyl cellosolve and dimethylformamide and 2 g of a solution of 10% by weight 2-ethyl-4-methylimidazole dissolved in methyl cellosolve were added to the obtained solution and mixed. Thus, a varnish composition was obtained. Subsequently, 100 µm glass cloth (WE 116E manufactured by Nitto Boseki Co., Ltd.) was impregnated with the varnish composition, and dried in a 150°C oven for 5 min. Thus, prepreg was obtained. Four plies of obtained prepreg were piled one upon another and cured at 170°C for 60 min by the use of a vacuum hot press machine. Thus, test pieces for combustion testing were obtained. Likewise, 12 plies of prepreg were formed into test pieces for Tg measuring; and four plies of prepreg were piled one upon another, interposed by copper foils of 18 µm thick (3EC-III manufactured by Mitsui Mining & Smelting Co., Ltd.) on the upper-side and the lower-side of said piled four piles of prepeg and formed into test pieces for copper foil bonding strength and thermal stability after moisture absorption testings. With respect to measurement results, the Tg was 174°C; the flame resistance was V-0 according to the standard UL-94; the copper foil peel strength was 14.1 N/cm; and, in the solder heat resistance after C-6/121/100 moisture absorption (after moisture absorption in a 121°C steam phase of 100% humidity for 6 hr), neither blistering nor peeling occurred.

### (Examples 2 to 7 and 9 to 11)

The same procedure as in Example 1 was repeated with respect to the phosphorous epoxy resins obtained in Synthetic Examples 1 to 7. The results are listed in Table 2.

### (Example 8)

The same procedure as in Example 1 was repeated with respect to the resin obtained by mixing 90 g of epoxy resin obtained in Synthetic Example 3 with 10 g of aralkylphenolic epoxy resin (E-XLC-LL produced by Mitsui Chemicals, Inc., epoxy equivalent: 244 g/eq). The results are listed in Table 2.

### (Comparative Examples 1 to 4)

The same procedure as in Example 1 was repeated with respect to the phosphorous epoxy resins obtained in Synthetic Examples 8 to 11. The evaluation results are listed in Table 3.

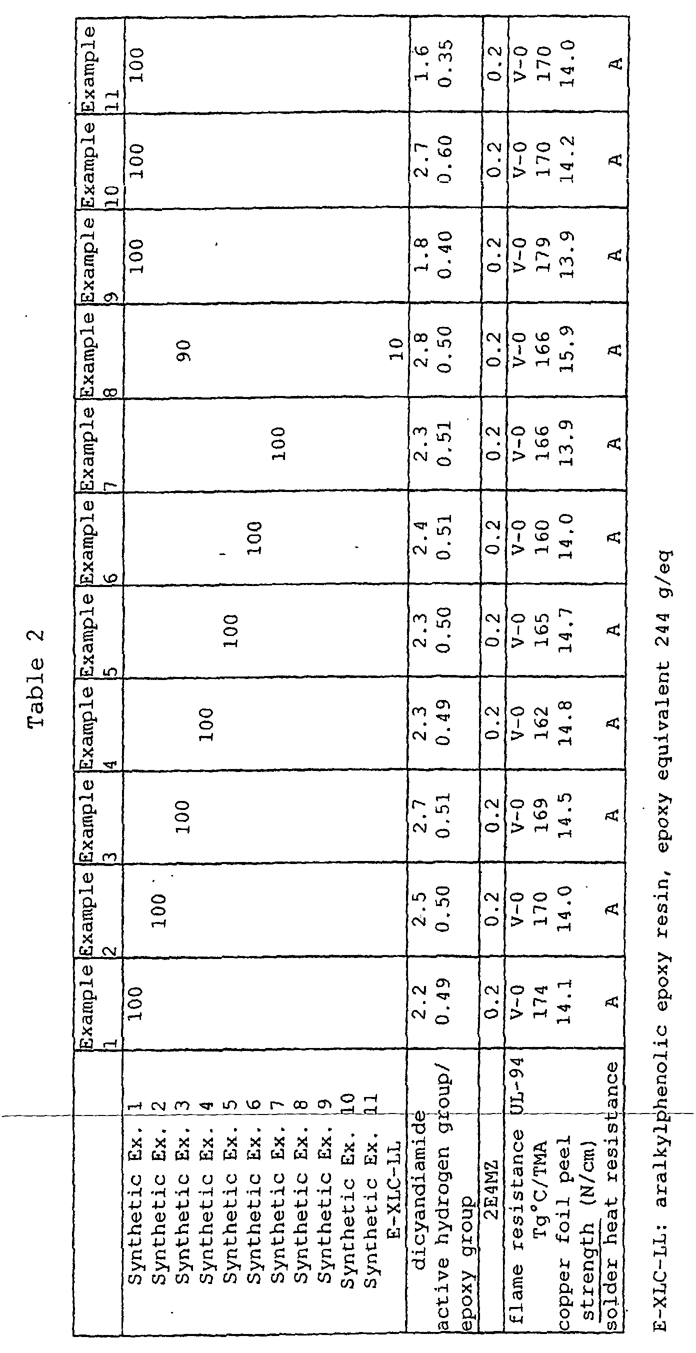

**Table 3**

| | Comp.Ex. 1 | Comp.Ex. 2 | Comp.Ex. 3 | Comp.Ex. 4 |
|---|---|---|---|---|
| Synthetic Ex. 1 | | | | |
| Synthetic Ex. 2 | | | | |
| Synthetic Ex. 3 | | | | |
| Synthetic Ex. 4 | | | | |
| Synthetic Ex. 5 | | | | |
| Synthetic Ex. 6 | | | | |
| Synthetic Ex. 7 | | | | |
| Synthetic Ex. 8 | 100 | | | |
| Synthetic Ex. 9 | | 100 | | |
| Synthetic Ex. 10 | | | 100 | |
| Synthetic Ex. 11 | | | | 100 |
| E-XLC-LL | | | | |
| dicyandiamide | - | - | 2.3 | 2.5 |
| active hydrogen | | | 0.49 | 0.50 |
| group / epoxy group | | | | |
| 2E4MZ | - | - | 0.2 | 0.3 |
| flame resistance | unable to evaluate | unable to evaluate | V-0 | V-0 |
| UL-94 | | | | |
| Tg°C/TMA | | | 145 | 160 |
| copper foil peel | | | 14.5 | 11.8 |
| strength (N/cm) | | | | |
| solder heat | | | A | C |
| resitance | | | | |

## Claims

1. A phosphorous epoxy resin being obtainable by reacting 5 to 50 parts by weight of an organophosphorus compound, 30 to 70 parts by weight of a trifunctional epoxy resin, 5 to 50 parts by weight of a bifunctional epoxy resin and 0 to 20 parts by weight of a bifunctional phenol compound (provided that organophosphorus compound + trifunctional epoxy resin + bifunctional epoxy resin + bifunctional phenol compound = 100 parts by weight).

2. The phosphorous epoxy resin as claimed in claim 1, wherein the organophosphorus compound is an organophosphorus compound capable of reacting with an epoxy group.

3. The phosphorous epoxy resin as claimed in claim 2, wherein the organophosphorus compound has two or more active hydrogens, and wherein the trifunctional epoxy resin has an aromatic ring.

4. The phosphorous epoxy resin as claimed in claim 2 or 3, wherein the organophosphorus compound is an organophosphorus compound obtained by reacting a compound having one active hydrogen bonded with a phosphorus atom with a quinone compound.

5. The phosphorous epoxy resin as claimed in any of claims 1 to 4, which has an epoxy equivalent of 250 to 1000 g/eq.

6. A flame-resistant highly thermally stable epoxy resin composition comprising the phosphorous epoxy resin as claimed in any of claims 1 to 5 and a curing agent.

7. A prepreg obtained with the use of the flame-resistant highly thermally stable epoxy resin composition of claim 6.

8. A laminate obtained with the use of the flame-resistant highly thermally stable epoxy resin composition of claim 6.
